# EUROPEAN PATENT APPLICATION

(11) **EP 4 141 141 A1**
(43) Date of publication of application: **01.03.2023**
(21) Application number: 22192083.8
(22) Date of filing: 25.08.2022
(51) Int. Cl.: C23C 16/455, C23C 16/34, C23C 16/40, C23C 16/44

(54) **FILM FORMING APPARATUS**

(30) Priority: 30.08.2021 JP 2021140476
(71) Applicant: Creative Coatings Co., Ltd., Shinjuku-ku Tokyo 162-0842 (JP)
(72) Inventor: SATO, Eiji, Tokyo (JP); SAKAMOTO, Hitoshi, Niigata (JP)
(74) Representative: Wunderlich & Heim Patentanwälte Partnerschaftsgesellschaft mbB

(57) **Abstract**

A film forming apparatus (10) configured to form a metal oxide film or a metal nitride film through atomic layer deposition by alternately introducing metal compound gas and an OH radical or an NH radical in a reaction container (20). The film forming apparatus (10) including: the reaction container (20); and at least one plasma generator (44,54,94) provided outside the reaction container and configured to generate a first plasma (PI) including an oxygen radical or a nitrogen radical when oxygen or nitrogen is supplied and generate a second plasma (P2) including a hydrogen radical when hydrogen is supplied. The OH radical is generated by collision between the oxygen radical and the hydrogen radical or the NH radical is generated by collision between the nitrogen radical and the hydrogen radical in a downstream region from an outlet of the at least one plasma generator to an inner space of the reaction container.

## Description

### BACKGROUND

The present invention relates to, for example, a film forming apparatus that forms a metal oxide film or a metal nitride film on a subject in a reaction container by using an OH radical or an NH radical through atomic layer deposition (ALD).

By using an OH radical, a resist is removed in JP-A-2008-085231 and JP-A-2008-109050, bacteria in water are killed in JP-A-2012-096141, substances to be purged are decomposed to perform clarification in JP-A-2013-086072, nitric acid is produced in JP-A-2016-150888, an organic binder or a protective agent undergoes oxidative destruction from above a conductive layer to improve conductivity in JP-A-2020-113654, and a metal oxide film is formed on powder by ALD in JP-B-6787621 by the present applicant. In JP-A-2008-085231, JP-A-2008-109050, JP-A-2012-096141, JP-A-2013-086072, JP-A-2016-150888, JP-A-2020-113654, JP-B-6787621, and JP-B-4694209, an OH radical is generated by plasma excitation on water vapor. Furthermore, in JP-B-6787621, a metal nitride film is formed by using an NH radical. The NH radical is generated by plasma excitation on NH₃.

In JP-B-4694209, an oxygen radical necessary for forming an oxide film on a substrate is generated by plasma excitation on oxygen O₂ and hydrogen H₂ in a treatment chamber. Thus, unlike in the use of H₂O or ozone O₃, a moisture generator or an ozone generator is not necessary, contributing to cost reduction.

According to JP-A-2008-085231, JP-A-2008-109050, JP-A-2012-096141, JP-A-2013-086072, JP-A-2016-150888, JP-A-2020-113654, JP-B-6787621, and JP-B-4694209, a moisture generator for generating an OH radical is necessary, and the introduction of water vapor to a subject of treatment less resistant to moisture may cause damage to a surface of the subject of treatment.

According to JP-B-6787621, in a process of generating NH^{∗} (^{∗} indicates a radical) by decompose NH₃ by plasma, it is assumed that the following states are mixed:

NH₃ → NH^{∗} + 2H^{∗} → NH^{∗} + H₂

NH₃ → NH₂ + N^{∗} → NH^{∗} + 2H^{∗} → NH^{∗} + H₂

NH₃ → N^{∗} + 3H^{∗} → NH^{∗} + 2H^{∗} → NH^{∗} + H₂

An NH radical is generated with low efficiency because of the mixed states.

According to JP-B-4694209, in a process of decomposing oxygen O₂ and hydrogen H₂ by heat at 500°C to 600°C to generate an oxygen radical O^{∗}, thermal reactions occur as follows (paragraph [0032]):

H₂ + O₂ → H^{∗} + HO₂

O₂ + H^{∗} → OH^{∗} + O^{∗}

H₂ + O^{∗} → H^{∗} + OH^{∗}

H₂ + OH^{∗} → H^{∗} + H₂O

Although JP-B-4694209 does not aim at generating OH^{∗} (OH radical), the thermal excitation of oxygen O₂ and hydrogen H₂ generates OH^{∗} (OH radical). However, an OH radical is generated with low efficiency because of the mixed states. This is because in the treatment chamber of JP-B-4694209, a collision of oxygens or hydrogens leads to a reaction that causes transition to a stabilized system as follows:

O + O → O₂

H + H → H₂

O + OH → O₂H

H + OH → H₂O

### SUMMARY OF THE INVENTION

The invention provides a film forming apparatus that efficiently generates an OH radical or an NH radical with high reactivity to improve the efficiency of film formation, the OH or NH radical being necessary for forming a metal oxide film or a metal nitride film on a subject in a reaction container by ALD.
(1) In accordance with one of some aspect, there is provided a film forming apparatus configured to form a metal oxide film or a metal nitride film through atomic layer deposition by alternately introducing metal compound gas and an OH radical or an NH radical in a reaction container,
   the film forming apparatus comprising:
   the reaction container; and
   at least one plasma generator provided outside the reaction container and configured to generate a first plasma including an oxygen radical or a nitrogen radical when oxygen or nitrogen is supplied and generate a second plasma including a hydrogen radical when hydrogen is supplied,
   wherein the OH radical is generated by collision between the oxygen radical and the hydrogen radical or the NH radical is generated by collision between the nitrogen radical and the hydrogen radical in a downstream region from an outlet of the at least one plasma generator to an inner space of the reaction container.

According to one aspect of the invention, from metal compound gas adsorbed to an object in the reaction container, organic substances or inorganic substances other than metallic components are dissociated by an OH radical, and the metal compound gas is oxidized into metal oxide by the OH radical. Alternatively, from metal compound gas adsorbed to an object in the reaction container, organic substances or inorganic substances other than metallic components are dissociated by an NH radical, and the metal compound gas is nitrided into metal nitride by the NH radical. The metal oxide or the metal nitride is sequentially deposited at an atomic layer level, so that a metal oxide film or a metal nitride film is formed on the object.

If the carrier gas is, for example, argon Ar, the first plasma includes an oxygen radical O^{∗} or a nitrogen radical N^{∗} that is dissociated from an oxygen molecule or a nitrogen molecule as indicated in expressions (1) and (2) below. Moreover, electrons and ions are dissociated in the first plasma. It is assumed that many of the electrons and the ions are deactivated downstream of the first plasma and only the oxygen radical and the nitrogen radical, which are protected by carrier gas Ar, are left in the pipe.

O₂ + Ar → 2O^{∗} + Ar ... (1)

N₂ + Ar → 2N^{∗} + Ar ... (2)

In the second plasma, a hydrogen radical dissociated from a hydrogen molecule is included as indicated by expression (3) below. Also in this case, it is assumed that electrons and ions in the second plasma are deactivated and only the hydrogen radical protected by the carrier gas Ar is left.

H₂ + Ar → 2H^{∗} + Ar ... (3)

In a downstream region from an outlet of the at least one plasma generator to an inner space of the reaction container, the oxygen radical O^{∗} or the nitrogen radical N^{∗} and the hydrogen radical H^{∗} are in time division or simultaneously introduced and merged each other. With this configuration, the oxygen radical O^{∗} or the nitrogen radical N^{∗} and the hydrogen radical H^{∗} are joined to collide with each other, thereby generating an OH radical or an NH radical by a reaction expressed in (4) or (5) below.

O^{∗} + H^{∗} + Ar → OH^{∗} + Ar ... (4)

N^{∗} + H^{∗} + Ar → NH^{∗} + Ar ... (5)

In other words, in (4), the oxygen radical O^{∗} and the hydrogen radical H^{∗}, which are in time division or simultaneously introduced into the reaction container and are caused to collide and are coupled with each other for the first time in the reaction container so as to mainly generate an OH radical. Thus, as compared with the generation process of JP-B-4694209 in which thermal excitation is simultaneously performed on oxygen O₂ and hydrogen H₂ in a treatment container so as to generate an OH radical, the invention can more efficiently generate an OH radical. Likewise, mainly in (5), a nitrogen radical N^{∗} and a hydrogen radical H^{∗} are coupled to each other to mainly generate an NH radical. Thus, as compared with the generation process of JP-B-6787621 in which NH₃ is excited to generate an NH radical, the invention can more efficiently generate an NH radical.

(2) In aspect (1) of the invention, the film forming apparatus may further comprises:
a first gas source configured to supply oxygen or nitrogen;
a second gas source configured to supply hydrogen;
a third gas source configured to supply carrier gas;
a first pipe causing the first gas source and the third gas source to communicate with the reaction container; and
a second pipe causing the second gas source and the third gas source to communicate with the reaction container; and
wherein the at least one plasma generator includes:
   a first plasma generator attached to the first pipe and configured to generate the first plasma;
   a second plasma generator attached to the second pipe and configured to generate the second plasma.

In this way, oxygen radicals and hydrogen radicals are supplied to the reaction container through separate routes. In this way, oxygen radicals and hydrogen radicals can be simultaneously supplied, for example, to the inner space of the reaction container located downstream of the outlets of the first and second plasma generators.

(3) In aspect (2) of the invention, at least one of the first pipe and the second pipe includes a first charged particle remover, and the first charged particle remover can remove charged particles including dissociated ions and/or electrons in the plasma in the first plasma generator and the second plasma generator, by using charge of the charged particles. With this configuration, positive ions having positive charge, negative ions having negative charge, and electrons or the like are neutralized by emitting/injecting excessive electrons or additionally required electrons from the metallic pipe. In this way, charged particles including positive ions, negative ions, and electrons that are generated by the first and second plasma generators are removed by using charge held by the charged particles. Thus, an oxygen radical or a nitrogen radical and a hydrogen radical are mainly supplied into the reaction container. This can more efficiently generate an OH radical or an NH radical in the reaction container.

(4) In aspect (2) of the invention, the first pipe and the second pipe may be coupled to the reaction container via a junction pipe. Thus, the reaction in (4) or (5) can be more efficient in a junction pipe that can be designed with a sufficiently smaller capacity than the reaction container, so that an OH radical or an NH radical that is generated in the junction pipe can be supplied into the reaction container.

(5) Also in aspect (3) of the invention, the first pipe and the second pipe may be coupled to the reaction container via the junction pipe. Thus, the same effect can be obtained as in aspects (1) to (3) of the invention.

(6) Also in aspect (4) or (5) of the invention, the junction pipe includes a second charged particle remover, and the second charged particle remover can remove charged particles including dissociated ions and/or electrons in the plasma in the first plasma generator and the second plasma generator, by using charge of the charged particles. Thus, the same effect can be obtained as in aspects (1), (2) and (4) of the invention. In other words, charged particles including positive ions, negative ions, and electrons that are generated by the first and second plasma generators are removed by using charge held by the charged particles. Thus, an oxygen radical or a nitrogen radical and a hydrogen radical are mainly supplied into the junction pipe. Furthermore, positive ions, negative ions, and electrons or the like that are left in the junction pipe are removed by using charge held by the ions and electrons. This can more efficiently supply an OH radical or an NH radical into the reaction container.

(7) In aspect (2) or (3) of the invention, the first pipe has a first valve between the first plasma generator and the reaction container, the second pipe has a second valve between the second plasma generator and the reaction container, and one of the first valve and the second valve may be closed while the other of the first valve and the second valve is opened. Thus, when the first valve is opened, an oxygen radical or a nitrogen radical that is generated by the first plasma generator is supplied into the reaction container. At this point, the second valve is closed, thereby preventing the oxygen radical or the nitrogen radical from flowing into the second plasma generator. Before or after this point, when the second valve is opened, a hydrogen radical generated by the second plasma generator is supplied into the reaction container. At this point, the first valve is closed, thereby preventing the hydrogen radical from flowing into the first plasma generator.

(8) In aspect (1) of the invention,
the film forming apparatus further comprising:
a first gas source configured to supply oxygen or nitrogen;
a second gas source configured to supply hydrogen;
a third gas source configured to supply carrier gas;
a first pipe coupled to the first gas source and the third gas source; and
a second pipe coupled to the second gas source and the third gas source; and
a junction pipe having one end coupled to the first pipe and the second pipe and the other end coupled to the reaction container; and
wherein the at least one plasma generator is a plasma generator attached to the junction pipe and configured to generate the first and the second plasma, and wherein:
   the first pipe has a first valve upstream of the plasma generator;
   the second pipe has a second valve upstream of the plasma generator;
   the plasma generator generates plasma including an oxygen radical or a nitrogen radical when the first valve is opened and the second valve is closed, the radical being dissociated from the oxygen or the nitrogen;
   the plasma generator generates plasma including a hydrogen radical when the second valve is opened and the first valve is closed, the radical being dissociated from the hydrogen; and
   in the reaction container, the OH radical is generated by collision between the oxygen radical and the hydrogen radical, or the NH radical is generated by collision between the nitrogen radical and the hydrogen radical.

Thus, when the first valve is opened and the second valve is closed, an oxygen radical or a nitrogen radical that is generated by only one plasma generator is supplied into the reaction container. Before or after this point, when the second valve is opened and the first valve is closed, a hydrogen radical generated by one plasma generator is supplied into the reaction container.

(9) Also in aspect (8) of the invention, the junction pipe includes a charged particle remover, and the charged particle remover can remove charged particles including dissociated ions and/or electrons in the plasma in the plasma generator, by using charge of the charged particles. Thus, the same effect can be obtained as in aspect (5) of the invention.

### BRIEF DESCRIPTION OF THE DRAWINGS

FIG. 1 illustrates a first embodiment and a second embodiment of a film forming apparatus according to the invention;
FIG. 2 is a timing chart indicating the opening/closing operations of valves in the first embodiment;
FIG. 3 is a timing chart indicating a cycle of ALD performed in the first embodiment;
FIG. 4 is a timing chart indicating the opening/closing operations of valves in the second embodiment;
FIG. 5 is a timing chart indicating a cycle of ALD performed in the second embodiment;
FIG. 6 illustrates a third embodiment of a film forming apparatus according to the invention;
FIG. 7 illustrates a fourth embodiment of a film forming apparatus according to the invention;
FIG. 8 is a timing chart indicating the opening/closing operations of valves in the fourth embodiment; and
FIG. 9 illustrates a structure in which positive ions and negative ions or the like are removed at an intermediate point of a pipe by using charge held by the ions.

### DESCRIPTION OF EXEMPLARY EMBODIMENTS

The following disclosure provides many different embodiments, or examples, for implementing different features of the provided subject matter. These are, of course, merely examples and are not intended to be limiting. In addition, the disclosure may repeat reference numerals and/or letters in the various examples. This repetition is for the purpose of simplicity and clarity and does not in itself dictate a relationship between the various embodiments and/or configurations discussed. Further, when a first element is described as being "connected" or "coupled" to a second element, such description includes embodiments in which the first and second elements are directly connected or coupled to each other, and also includes embodiments in which the first and second elements are indirectly connected or coupled to each other with one or more other intervening elements in between.

In the following disclosure, different embodiments and examples are provided for implementing different characteristics of a presented subject. The embodiments and examples are merely exemplary and are not intended to be limiting. Furthermore, in the present disclosure, reference numerals and/or characters may be repeated in various examples. The repetition is performed for simplicity and clarification and does not need to be associated with various embodiments and/or described configurations. Moreover, a description that a first element is "connected" or "coupled" to a second element includes an embodiment in which the first element and the second element are directly connected or coupled to each other and an embodiment in which the first element and the second element are indirectly connected or coupled to each other with at least one element interposed between the first and second elements. When the first element "moves" relative to the second element in a description, such a description includes an embodiment of a movement of at least one of the first element and the second element relative to the other of the elements.

### 1. First Embodiment

### 1.1. ALD apparatus

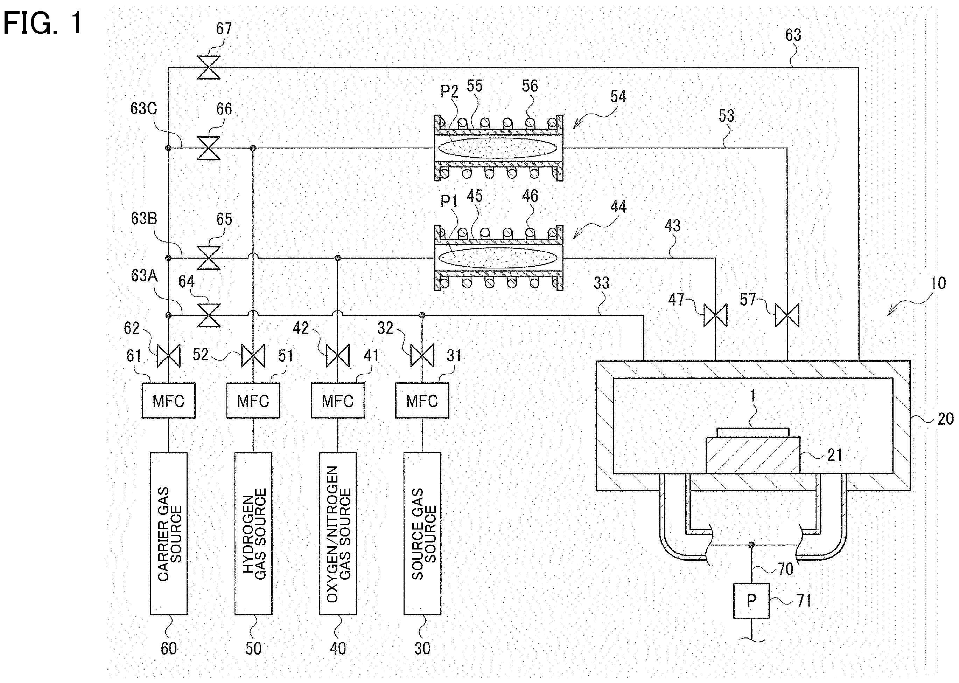

FIG. 1 illustrates an example of an ALD apparatus 10. The ALD apparatus 10 includes a reaction container 20 and at least one plasma generator provided outside the reaction container 20. In the present embodiment, at least one plasma generator includes a first plasma generator 44 and a second plasma generator 54. The ALD apparatus 10 further includes gas sources 30 to 60. The reaction container 20 is a container for forming a film on a workpiece 1. The reaction container 20 may include a placement part 21 on which the workpiece 1, e.g., a substrate is placed. If the workpiece is powder or the like, the powder may be held in a dispersed state in the reaction container 20. The gas sources 30 to 60 are coupled to the reaction container 20, and a variety of gas is introduced into the reaction container 20. An exhaust pipe 70 is coupled to the reaction container 20, allowing a vacuum pump 71 to evacuate the reaction container 20.

A source gas source 30 supplies metal compound gas, e.g., organic metallic gas that is source gas selected for a film deposited on the workpiece 1. The source gas source 30 and the reaction container 20 are coupled to each other via a pipe 33 including a flow controller (MFC) 31 and a valve 32. Source gas is supplied from the source gas source 30 into the reaction container 20 through the pipe 33 including the flow controller 31 and the valve 32 while the timing of supply and the flow rate are controlled.

An oxygen/nitrogen gas source 40 and a hydrogen gas source 50 are reactant gas sources. The oxygen/nitrogen gas source (first gas source) 40 contains oxygen when an oxide film is formed, and contains nitrogen when a nitride film is formed. The oxygen/nitrogen gas source 40 and the reaction container 20 are coupled to each other via a pipe 43 including a flow controller (MFC) 41, a valve 42, and a first plasma generator 44. A valve 47 on the pipe 43 is optional in the first embodiment. If the valve 47 is installed, the valve 47 is fully opened all the time. The hydrogen gas source 50 and the reaction container 20 are coupled to each other via a pipe 53 including a flow controller (MFC) 51, a valve 52, and a second plasma generator 54. A valve 57 on the pipe 53 is optional in the first embodiment. If the valve 57 is installed, the valve 57 is fully opened all the time.

A carrier gas source 60 contains inert gas, for example, argon Ar. In the present embodiment, argon Ar in the carrier gas source 60 is used as purge gas as well as carrier gas. For the use of gas, the carrier gas source 60 and the reaction container 20 can be coupled to each other via a pipe 63 including a flow controller (MFC) 61, a valve 62, and a valve 66. Thus, argon Ar is supplied as purge gas into the reaction container 20 through the pipe 63 while the timing of supply and the flow rate are controlled. This can substitute argon gas Ar for an atmosphere in the reaction container 20. The pipe 63 includes first to third branch pipes 63A to 63C downstream of the valve 62. The first branch pipe 63A is coupled to the pipe 33 via a valve 64. The second branch pipe 63B is coupled to the pipe 43 via a valve 65. The third branch pipe 63C is coupled to the pipe 53 via the valve 66. With this configuration, argon Ar can be used as a carrier gas for source gas, oxygen, nitrogen, or hydrogen.

The first plasma generator 44 includes an induction coil 46 that serves as exciting means of oxygen or nitrogen and is wound around a nonmetallic pipe 45 made of, for example, quartz. A high-frequency power supply, which is not illustrated, is connected to the induction coil 46. For example, the induction coil 46 applies electromagnetic energy of 20 W at a frequency of 13.56 MHz. The induction coil 46 generates inductively coupled plasma P1 of gas in the first plasma generator 44. The plasma P1 contains an oxygen radical or a nitrogen radical that is dissociated from an oxygen molecule or a nitrogen molecule.

Likewise, the second plasma generator 54 includes an induction coil 56 that serves as exciting means of hydrogen and is wound around a nonmetallic pipe 55 made of, for example, quartz. The induction coil 56 generates inductively coupled plasma P2 of gas in the second plasma generator 54. The plasma P2 contains a hydrogen radical dissociated from a hydrogen molecule.

### 1.2. ALD method

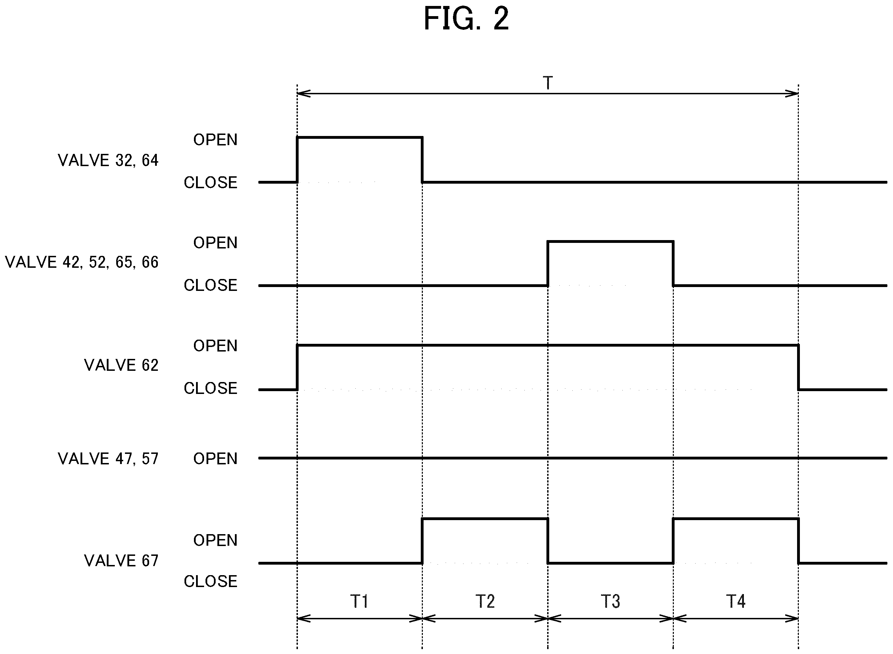

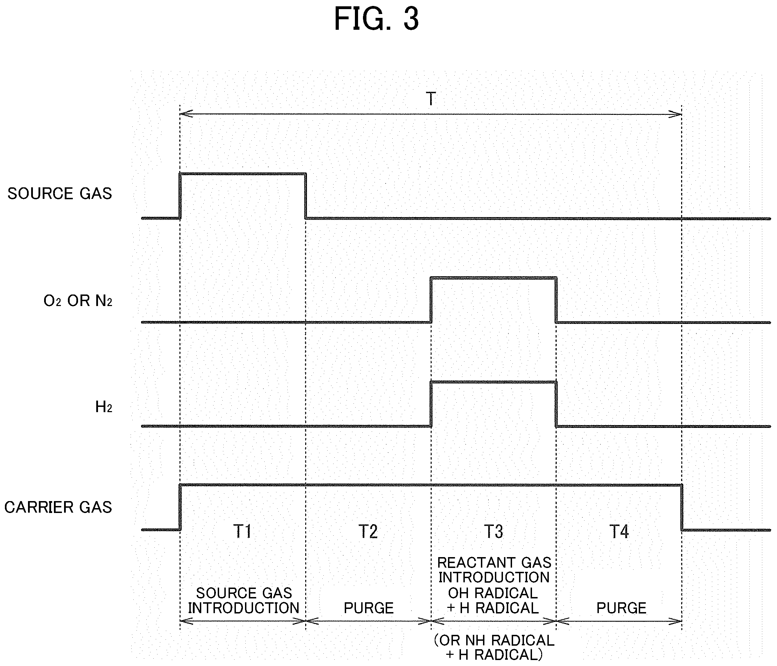

An example of the formation of a metal oxide film, e.g., an Al₂O₃ film on the workpiece 1 will be described below. The oxygen/nitrogen gas source 40 contains oxygen and thus is also referred to as an oxygen gas source 40 hereafter. First, the workpiece 1 is conveyed into the reaction container 20. In the first embodiment, the valves in FIG. 1 are opened and closed according to a timing chart in FIG. 2, so that an ALD cycle is performed as indicated in FIG. 3. The ALD cycle is a cycle including at least four steps of: the supply of a first precursor (source gas) → evacuation (including purge) → the supply of a second precursor (reactive gas) → evacuation (including purge). The evacuation is vacuum pumping through the vacuum pump 71, and the purge is the supply of inert gas (purge gas) from the carrier gas source 60. In either way, the atmosphere of the first or second precursor is substituted by a vacuum or purge gas atmosphere in the reaction container 20. The thickness of a film formed on the workpiece 1 is proportionate to N indicating the number of ALD cycles. Thus, the ALD cycle is repeated N times where N denotes a required number of times.

### 1.2.1. Supply of source gas

First, the reaction container 20 is evacuated by the vacuum pump 71 and is set at, for example, 10⁻⁴ Pa. Subsequently, as illustrated in FIG. 2, the valves 32, 62, and 64 are opened over a period T1. Thus, source gas, for example, TMA (Al(CH₃)₃) from the source gas source 30 and carrier gas, for example, argon Ar from the carrier gas source 60 are supplied into the reaction container 20, and the container is filled with the gas with a predetermined pressure, e.g., 1 to 10 Pa. In the first step (period T1) of the ALD cycle in FIG. 3, TMA penetrates the exposed surface of the workpiece 1.

### 1.2.2. Purge

Thereafter, as the second step of the ALD cycle, the valves 32 and 64 are closed, the valve 62 is kept opened, and a valve 67 is opened over a period T2 as indicated in FIG. 2. Thus, purge gas is introduced into the reaction container 20 as indicated in FIG. 3, and the purge gas substitutes for trimethylaluminum Al(CH₃)₃ in the reaction container 20.

### 1.2.3. Introduction of reactant gas

Thereafter, as the third step of the ALD cycle, the valve 67 is closed, the valve 62 is kept opened, and the valves 42, 52, 65, and 66 are opened over a period T3 as indicated in FIG. 2. Thus, oxygen gas from the oxygen gas source 40 and argon Ar as carrier gas from the carrier gas source 60 are supplied into the first plasma generator 44. Concurrently, hydrogen gas from the hydrogen gas source 50 and argon Ar as carrier gas from the carrier gas source 60 are supplied into the second plasma generator 54. In the first plasma generator 44, the inductively coupled plasma P1 including an oxygen radical is generated, the oxygen radical being dissociated from oxygen as indicated by the forgoing expression (1). The oxygen radical is supplied with carrier gas into the reaction container 20 through the pipe 43. In the second plasma generator 54, the inductively coupled plasma P2 including a hydrogen radical is generated, the hydrogen radical being dissociated from hydrogen as indicated by the forgoing expression (3). The hydrogen radical is supplied with carrier gas into the reaction container 20 through the pipe 53 by a route different from that of an oxygen radical. Thus, the oxygen radical and the hydrogen radical are simultaneously supplied to the inner space of the reaction container 20 located downstream of the outlets of the first and second plasma generators 44 and 54, for example.

In the reaction container 20, the oxygen radical and the hydrogen radical join for the first time. Thus, in the reaction container 20, an OH radical is generated by collision and combination of the oxygen radical and the hydrogen radical as indicated by the foregoing expression (4). The reaction container 20 is filled with the OH radical (OH^{∗}) as reactant gas with a predetermined pressure, e.g., 1 to 10 Pa (the period T3 in FIG. 3), so that the OH radical (OH^{∗}) penetrates the exposed surface of the workpiece 1. Hence, on the exposed surface of the workpiece 1, an organic substance CH₃ is dissociated from TMA(Al(CH₃)₃) and a metal Al is oxidized, so that aluminum oxide Al₂O₃ is generated. This forms a metal oxide film over the exposed surface of the workpiece 1. Organic metallic gas can be saturated and adsorbed particularly on a hydroxy group (-OH) of the exposed surface of the workpiece 1 even at room temperature. This eliminates the need for forcibly heating the workpiece 1 during the formation of the film.

### 1.2.4. Purge

Thereafter, as the fourth step of the ALD cycle, the valves 42, 52, 65, and 66 are closed, the valve 62 is kept opened, and the valve 67 is opened over a period T4 as indicated in FIG. 2. Thus, purge gas is introduced into the reaction container 20, and the purge gas substitutes for reactant gas in the reaction container 20. An Al₂O₃ film of 1 angstrom = 0.1 nm is formed in each cycle, so that the ALD cycle may be repeated 100 times to form the film with a thickness of, for example, 10 nm. At the completion of all the ALD cycles, the workpiece 1 is conveyed out of the reaction container 20.

### 2. Second Embodiment

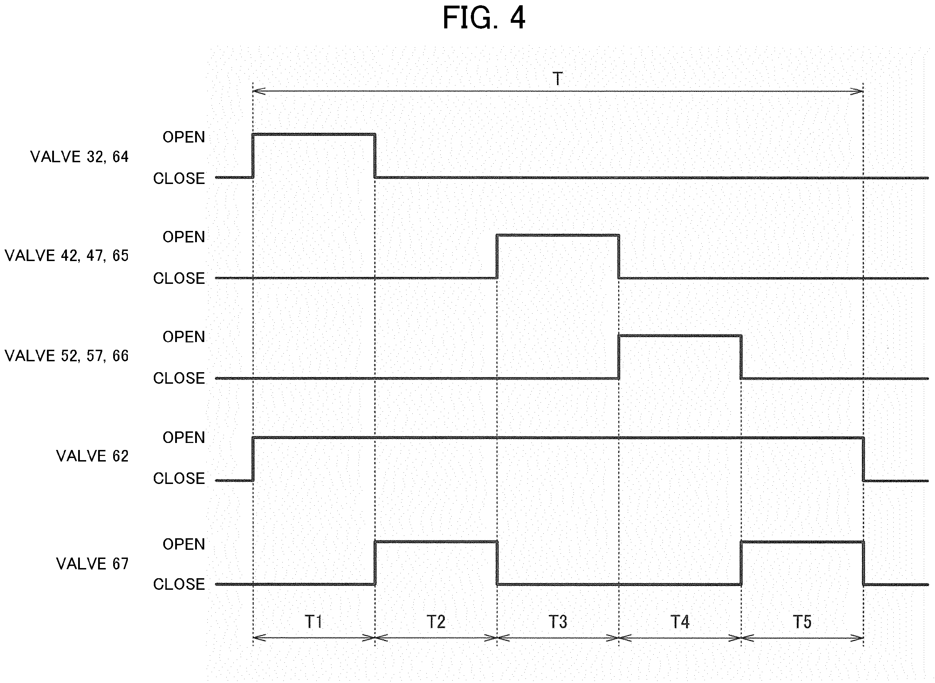

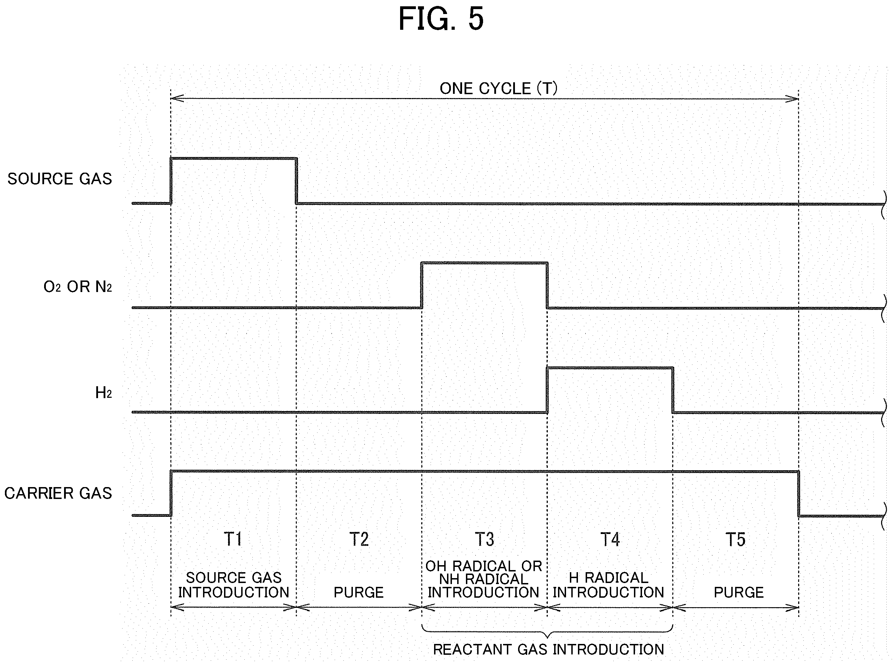

In a second embodiment, in the ALD apparatus 10 of FIG. 1, the valves in FIG. 1 are opened and closed according to a timing chart in FIG. 4, so that an ALD cycle is performed as indicated in FIG. 5. Unlike in the first embodiment, a valve 47 acting as a first valve and a valve 57 acting as a second valve are opened and closed in the second embodiment.

### 2.1. Supply of source gas

As illustrated in FIG. 4, valves 32, 62, and 64 are opened over a period T1. Thus, source gas, for example, TMA (Al(CH₃)₃) from a source gas source 30 and carrier gas, for example, argon Ar from a carrier gas source 60 are supplied into a reaction container 20, and the container is filled with the gas with a predetermined pressure, e.g., 1 to 10 Pa. In the first step (period T1) of the ALD cycle in FIG. 5, TMA penetrates the exposed surface of a workpiece 1.

### 2.2. Purge

Thereafter, as the second step of the ALD cycle, the valves 32 and 64 are closed, the valve 62 is kept opened, and a valve 67 is opened over a period T2 as indicated in FIG. 4. Thus, purge gas is introduced into the reaction container 20 as indicated in FIG. 5, and the purge gas substitutes for trimethylaluminum Al(CH₃)₃ in the reaction container 20.

### 2.3. Introduction of reactant gas

Subsequently, as the third step of the ALD cycle, the valve 67 is closed, the valve 62 is kept opened, and a valve 42, the valve 47, and a valve 65 are opened over a period T3 as indicated in FIG. 4. Thus, oxygen gas from an oxygen gas source 40 and argon Ar as carrier gas from the carrier gas source 60 are supplied into a first plasma generator 44. In the first plasma generator 44, an inductively coupled plasma P1 including an oxygen radical is generated, the oxygen radical being dissociated from oxygen as indicated by the forgoing expression (1). The oxygen radical is supplied with carrier gas into the reaction container 20 through a pipe 43. In this way, the reaction container 20 is filled with the oxygen radical with a predetermined pressure. At this point, the second valve 57 is closed, thereby preventing the oxygen radical from flowing into a second plasma generator 54.

Thereafter, as indicated in FIG. 4, the valves 42, 47, and 65 are closed, and the valve 52, the valve 57, and a valve 66 are opened over a period T4. Thus, hydrogen gas from a hydrogen gas source 50 is supplied into a second plasma generator 54 with argon Ar serving as carrier gas from the carrier gas source 60. In the second plasma generator 54, an inductively coupled plasma P2 including a hydrogen radical is generated, the hydrogen radical being dissociated from hydrogen as indicated by the forgoing expression (3). The hydrogen radical is supplied with carrier gas into the reaction container 20 through a pipe 53 by a route different from that of an oxygen radical. In this way, the reaction container 20 is filled with the hydrogen radical with a predetermined pressure. At this point, the first valve 47 is closed, thereby preventing the hydrogen radical from flowing into a first plasma generator 44.

In the reaction container 20, the oxygen radical and the hydrogen radical join for the first time. Thus, in the reaction container 20, an OH radical is generated by collision and combination of the oxygen radical and the hydrogen radical as indicated by the foregoing expression (4). The reaction container 20 is filled with the OH radical (OH^{∗}) as reactant gas with a predetermined pressure, e.g., 1 to 10 Pa (the period T4 in FIG. 5), so that the OH radical (OH^{∗}) penetrates the exposed surface of the workpiece 1. Hence, on the exposed surface of the workpiece 1, aluminum oxide Al₂O₃ is generated as in the first embodiment.

### 2.4. Purge

Thereafter, as the fourth step of the ALD cycle, the valves 52, 57, and 66 are closed, the valve 62 is kept opened, and the valve 67 is opened over a period T5 as indicated in FIG. 4. Thus, purge gas is introduced into the reaction container 20, and the purge gas substitutes for reactant gas in the reaction container 20.

### 3. Third Embodiment

### 3.1. ALD apparatus

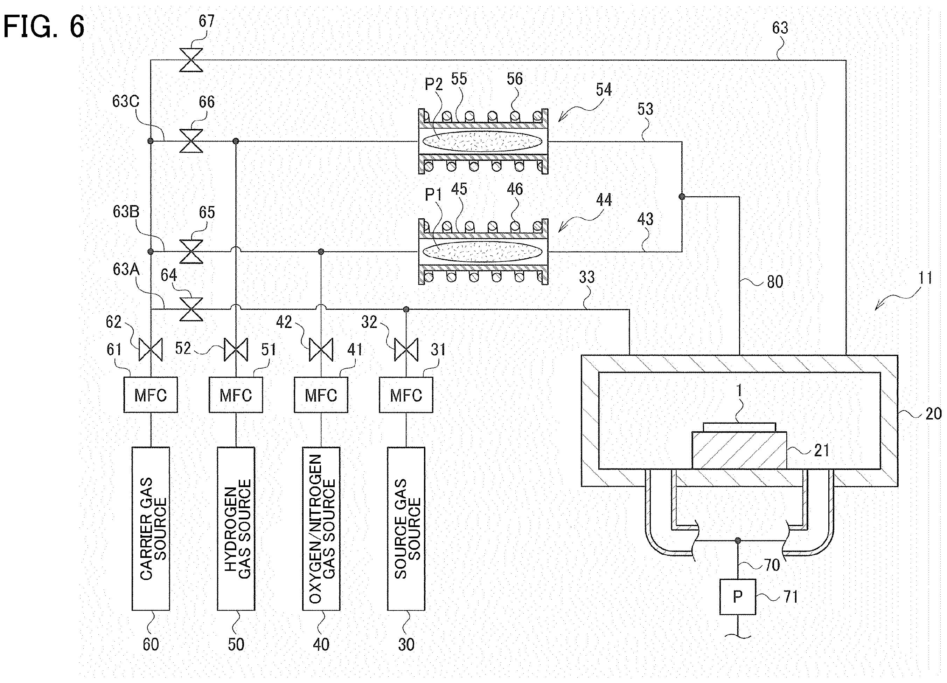

FIG. 6 illustrates an example of an ALD apparatus 11. In the ALD apparatus 11, members having the same functions as the members of the ALD apparatus 10 in FIG. 1 are indicated by the same reference numerals as in FIG. 1, and an explanation thereof is omitted. The ALD apparatus 11 includes a first pipe 43 and a second pipe 53 that are coupled to a reaction container 20 via a junction pipe 80.

### 3.2. ALD method

In a third embodiment, in the ALD apparatus 11 of FIG. 6, valves in FIG. 6 are opened and closed according to the timing chart in FIG. 2, so that an ALD cycle is performed as indicated in FIG. 3. An ALD method in the third embodiment is different from the first embodiment only in the introduction of reactant gas (third step) in a period T3, and thus operations in the period T3 will be discussed below.

As the third step of the ALD cycle, a valve 67 is closed, a valve 62 is kept opened, and valves 42, 52, 65, and 66 are opened over the period T3 as indicated in FIG. 2. Thus, oxygen gas from an oxygen gas source 40 and argon Ar as carrier gas from a carrier gas source 60 are supplied into a first plasma generator 44. Concurrently, hydrogen gas from a hydrogen gas source 50 and argon Ar as carrier gas from the carrier gas source 60 are supplied into a second plasma generator 54. In the first plasma generator 44, an inductively coupled plasma P1 including an oxygen radical is generated, the oxygen radical being dissociated from oxygen as indicated by the forgoing expression (1). The oxygen radical is supplied with carrier gas into a junction pipe 80 through a pipe 43. In the second plasma generator 54, an inductively coupled plasma P2 including a hydrogen radical is generated, the hydrogen radical being dissociated from hydrogen as indicated by the forgoing expression (3). The hydrogen radical is supplied with carrier gas into the junction pipe 80 through a pipe 53.

The oxygen radical and the hydrogen radical join for the first time in the junction pipe 80 located downstream of the outlets of the first and second plasma generators 44 and 54, for example. Thus, in the junction pipe 80, an OH radical is generated by collision and combination of the oxygen radical and the hydrogen radical as indicated by the foregoing expression (4). The OH radical (OH^{∗}) as reactant gas is supplied from the junction pipe 80 into the reaction container 20. The reaction container 20 is filled with the OH radical with a predetermined pressure, e.g., 1 to 10 Pa, so that the OH radical (OH^{∗}) penetrates the exposed surface of a workpiece 1. This forms a metal oxide film over the exposed surface of the workpiece 1 as in the first embodiment.

### 4. Fourth Embodiment

### 4.1. ALD apparatus

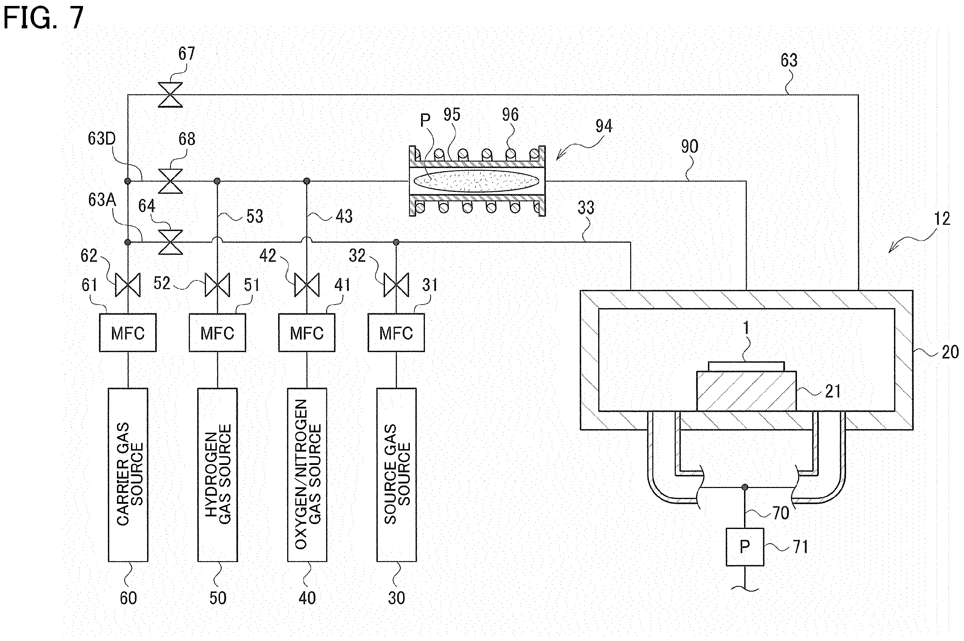

FIG. 7 illustrates an example of an ALD apparatus 12. In the ALD apparatus 12, members having the same functions as the members of the ALD apparatus 10 in FIG. 1 are indicated by the same reference numerals as in FIG. 1, and an explanation thereof is omitted. The ALD apparatus 12 includes a first pipe 43 and a second pipe 53 that are coupled to a reaction container 20 via a junction pipe 90. Furthermore, a plasma generator 94 is attached to the junction pipe 90. The junction pipe 90 is coupled to a branch pipe 63D, which is a branch from a pipe 63 of carrier gas, via a valve 68. In a fourth embodiment, a valve 42 and the valve 68 upstream of the plasma generator 94 act as first valves, and another valve 52 upstream of the plasma generator 94 acts as a second valve.

### 4.2. ALD method

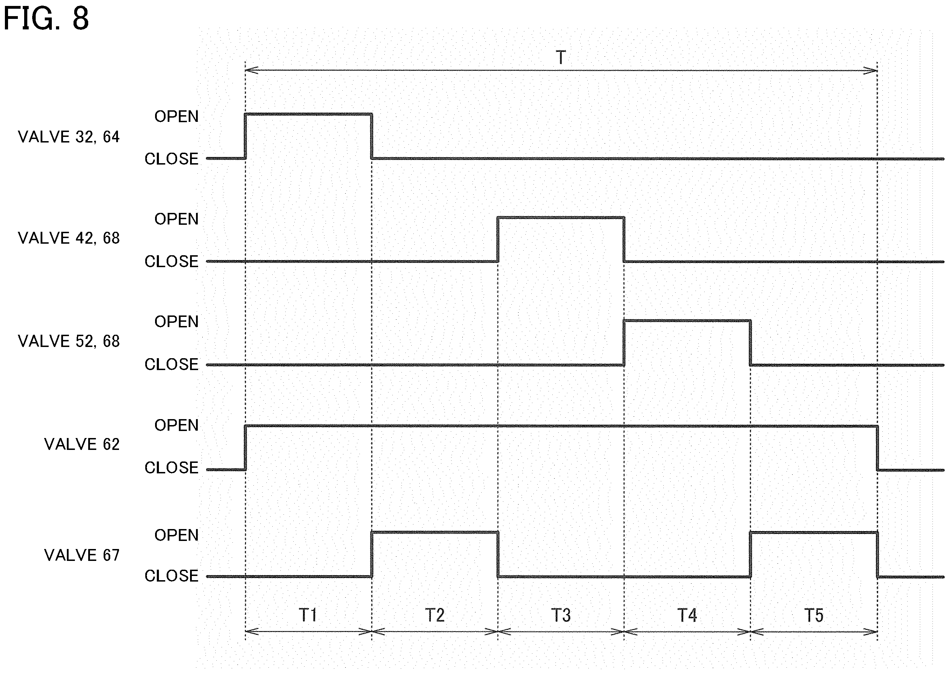

In the fourth embodiment, in the ALD apparatus 12 of FIG. 7, valves in FIG. 7 are opened and closed according to the timing chart in FIG. 8, so that an ALD cycle is performed as indicated in FIG. 5. An ALD method in the fourth embodiment is different from the second embodiment only in the introduction of reactant gas (third step) in periods T3 and T4, and thus operations in the periods T3 and T4 will be discussed below.

In FIG. 8, valve operations in periods T1, T2, and T5 are identical to those in FIG. 4. As the third step of the ALD cycle, a valve 67 is first closed, a valve 62 is kept opened, and the valves 42 and 68 are opened over the period T3 as indicated in FIG. 8. Thus, oxygen gas from an oxygen gas source 40 and argon Ar as carrier gas from a carrier gas source 60 are supplied into the first plasma generator 94. In the first plasma generator 94, an inductively coupled plasma P including an oxygen radical is generated, the oxygen radical being dissociated from oxygen as indicated by the forgoing expression (1). The oxygen radical is supplied with carrier gas into the reaction container 20 through the junction pipe 90. In this way, the reaction container 20 is filled with the oxygen radical with a predetermined pressure.

Subsequently, the valve 42 is closed, the valve 62 is kept opened, and a valve 52 and the valve 68 are opened over the period T4 as indicated in FIG. 8. Thus, hydrogen gas from a hydrogen gas source 50 and argon Ar as carrier gas from a carrier gas source 60 are supplied into the plasma generator 94. In the plasma generator 94, an inductively coupled plasma P including a hydrogen radical is generated, the hydrogen radical being dissociated from hydrogen as indicated by the forgoing expression (3). The hydrogen radical is supplied with carrier gas into the reaction container 20 through the junction pipe 90. In this way, the reaction container 20 is filled with the hydrogen radical with a predetermined pressure.

The oxygen radical and the hydrogen radical join for the first time in the reaction container 20 located downstream of the outlet of the plasma generators 94, for example. Thus, in the reaction container 20, an OH radical is generated by collision and combination of the oxygen radical and the hydrogen radical as indicated by the foregoing expression (4). The reaction container 20 is filled with the OH radical (OH^{∗}) as reactant gas with a predetermined pressure, e.g., 1 to 10 Pa (the period T4 in FIG. 8), so that the OH radical (OH^{∗}) penetrates the exposed surface of the workpiece 1. Hence, on the exposed surface of the workpiece 1, aluminum oxide Al₂O₃ is generated as in the first embodiment.

### 5. Modification

Instead of reactant gas used for forming a metal oxide film, nitrogen gas can be used to form a metal oxide film. In this case, the oxygen/nitrogen gas source 40 in, for example, FIG. 1 contains oxygen. Thus, an NH radical can be efficiently generated by using a nitride radical (N^{∗}) and a hydrogen radical (H^{∗}). For example, by using TDMAS(SiH[N(CH₃)₂]₃) as source gas, a film of SiN can be formed on the surface of the workpiece 1. For example, by using TDMAS(Ti[N(CH₃)₂]₄) as source gas, TiN can be deposited on the surface of the workpiece 1. In either case, a low-temperature process can be achieved by the presence of the NH radical.

The source gas is not limited to the foregoing organometallic compounds, and an inorganic metal compound may be used instead. For example, if SiCl₄ is supplied as inorganic metal compound gas to the surface of the substrate 1, the gas is adsorbed by SiCl₂, and then the gas is exhausted after Cl₂ is desorbed.

SiCl₄ → SiCl₂ + Cl₂↑

When an OH radical is supplied in this state, SiCl₂ is oxidized into SiO₂, and then the gas is exhausted after HCl is desorbed.

SiCl₂ + OH → SiO₂ + 2HCl↑

Additionally, a metal oxide film can be similarly formed by using TiCl₄ or SiH2Cl₂ as another inorganic metal compound gas.

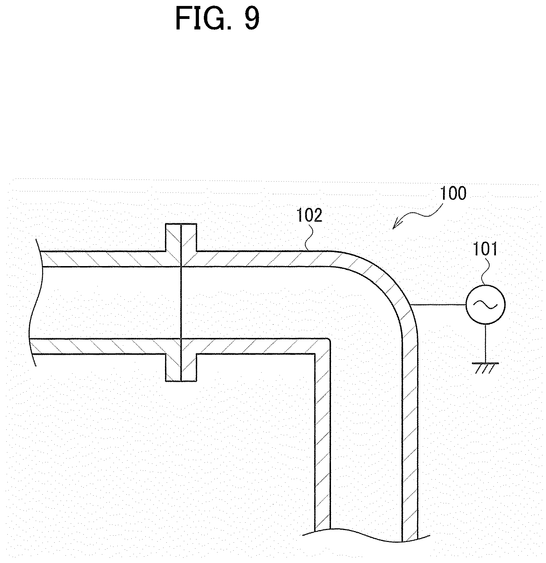

Downstream of the first and second plasma generator 44 and 54 or the plasma generator 94, the pipe 43 and the pipe 53, which supply an oxygen radical, a hydrogen radical, or an OH radical into the reaction container 20 in FIG. 1, and the junction pipe 80 in FIG. 6 or the junction pipe 90 in FIG. 7 may include, for example, a metallic pipe 100 illustrated in FIG. 9. For example, an alternating-current power supply 101 that applies an alternating voltage changing from -100 V to +100 V at 10 Hz to 100 Hz may be connected to the metallic pipe 100. It is particularly preferable to dispose a metallic bending pipe 102 in the metallic pipe 100 in FIG. 9. With this configuration, positive ions or the like having positive charge are adsorbed by the pipe 100 when a negative voltage is applied to the metallic pipe 100, whereas charged particles such as negative ions having negative charge are adsorbed by the pipe 100 when a positive voltage is applied to the metallic pipe 100. Furthermore, the ions and charged particles are neutralized by emitting/injecting excessive electrons or additionally required electrons from the metallic pipe. In this way, positive ions, negative ions, and electrons or the like are removed by using charge held by the ions and electrons. Thus, in the first and second embodiments, an oxygen radical or a nitrogen radical and a hydrogen radical are mainly supplied into the reaction container 20. In the third embodiment, an oxygen radical or a nitrogen radical and a hydrogen radical are mainly supplied into the junction pipe 80, and an OH radical or an NH radical is mainly supplied into the reaction container 20. In the fourth embodiment, an oxygen radical or a nitrogen radical and a hydrogen radical are mainly supplied into the junction pipe 90, and an OH radical or an NH radical is mainly supplied into the reaction container 20. The charged particle remover may be the installed metallic pipe 100. Alternatively, the charged particle remover may be a mesh disposed at an intermediate point of the pipe, the mesh including charge adsorption fibers. The charge adsorption fibers may be grounded or may be connected to an alternating-current power supply.

Although only some embodiments of the present invention have been described in detail above, those skilled in the art will readily appreciate that many modifications are possible in the embodiments without materially departing from the novel teachings and advantages of this invention. Accordingly, all such modifications are intended to be included within scope of this invention.

### REFERENCE SIGNS LIST

1 Workpiece
10 to 12 ALD apparatus
20 Reaction container
30 Source gas source
31, 41, 51, 61 Flow controller
32, 42, 52, 62, 64, 66 to 68Valve
33 Pipe
40 Oxygen/nitrogen gas source (first gas source)
42 First valve
43, 63, 63A First pipe
44 First plasma generator
47 First valve
50 Hydrogen gas source (second gas source)
52 Second valve
53, 63, 63B Second pipe
54 Second plasma generator
57 Second valve
60 Carrier gas source (third gas source)
70 Exhaust pipe
71 Vacuum pump
80, 90Junction pipe
94 Plasma generator
100 to 102 Charged particle remover
100 Metallic pipe
101 Alternating-current power supply
102 Bending pipe

## Claims

1. A film forming apparatus configured to form a metal oxide film or a metal nitride film through atomic layer deposition by alternately introducing metal compound gas and an OH radical or an NH radical in a reaction container,
the film forming apparatus comprising:
the reaction container; and
at least one plasma generator provided outside the reaction container, and configured to generate a first plasma including an oxygen radical or a nitrogen radical when oxygen or nitrogen is supplied and generate a second plasma including a hydrogen radical when hydrogen is supplied,
wherein the OH radical is generated by collision between the oxygen radical and the hydrogen radical or the NH radical is generated by collision between the nitrogen radical and the hydrogen radical in a downstream region from an outlet of the at least one plasma generator to an inner space of the reaction container.

2. The film forming apparatus according to claim 1,
the film forming apparatus further comprising:
a first gas source configured to supply oxygen or nitrogen;
a second gas source configured to supply hydrogen;
a third gas source configured to supply carrier gas;
a first pipe causing the first gas source and the third gas source to communicate with the reaction container; and
a second pipe causing the second gas source and the third gas source to communicate with the reaction container; and
wherein the at least one plasma generator includes:
a first plasma generator attached to the first pipe and configured to generate the first plasma;
a second plasma generator attached to the second pipe and configured to generate the second plasma.

3. The film forming apparatus according to claim 2, wherein at least one of the first pipe and the second pipe includes a first charged particle remover, and the first charged particle remover removes charged particles including dissociated ions and/or electrons generated in the first plasma and/or the second plasma by using charge of the charged particles.

4. The film forming apparatus according to claim 2, wherein the first pipe and the second pipe are coupled to the reaction container via a junction pipe.

5. The film forming apparatus according to claim 3, wherein the first pipe and the second pipe are coupled to the reaction container via a junction pipe.

6. The film forming apparatus according to claim 4 or 5, wherein the junction pipe includes a second charged particle remover, and the second charged particle remover removes charged particles including dissociated ions and/or electrons generated in the first plasma and/or the second plasma by using charge of the charged particles.

7. The film forming apparatus according to claim 2 or 3, wherein the first pipe has a first valve between the first plasma generator and the reaction container,
the second pipe has a second valve between the second plasma generator and the reaction container, and
one of the first valve and the second valve is closed while the other of the first valve and the second valve is opened.

8. The film forming apparatus according to claim 1,
the film forming apparatus further comprising:
a first gas source configured to supply oxygen or nitrogen;
a second gas source configured to supply hydrogen;
a third gas source configured to supply carrier gas;
a first pipe coupled to the first gas source and the third gas source;
a second pipe coupled to the second gas source and the third gas source; and
a junction pipe having one end coupled to the first pipe and the second pipe and the other end coupled to the reaction container; and
wherein the at least one plasma generator is a plasma generator attached to the junction pipe and configured to generate the first plasma and the second plasma, and wherein:
the first pipe has a first valve upstream of the plasma generator;
the second pipe has a second valve upstream of the plasma generator;
the plasma generator generates the first plasma when the first valve is opened and the second valve is closed;
the plasma generator generates the second plasma when the second valve is opened and the first valve is closed.

9. The film forming apparatus according to claim 8, wherein the junction pipe includes a charged particle remover, and the charged particle remover removes charged particles including dissociated ions and/or electrons generated in the first plasma and the second plasma by using charge of the charged particles.
